# EUROPEAN PATENT SPECIFICATION

(11) **EP 3 436 624 B1**
(45) Date of publication and mention of the grant of the patent: **30.11.2022**
(21) Application number: 17715374.9
(22) Date of filing: 24.03.2017
(51) Int. Cl.: C30B 15/00, C30B 15/10, C30B 15/14, C30B 29/06

(54) **CRYSTAL GROWTH APPARATUS AND RELATED METHODS**
KRISTALLZÜCHTUNGSVORRICHTUNG UND ZUGEHÖRIGE VERFAHREN
APPAREIL DE CROISSANCE DE CRISTAUX ET PROCÉDÉS ASSOCIÉS

(30) Priority: 29.03.2016 US 201662314562 P
(43) Date of publication of application: 06.02.2019
(73) Proprietor: Corner Star Limited, Hong Kong (CN)
(72) Inventor: LUTER, William Lynn, St. Charles, Missouri 63303 (US)
(74) Representative: Parchmann, Stefanie
(86) International application number: PCT/US2017/024091
(87) International publication number: WO 2017/172530

(56) References cited:
- DE-T5-112014 001 076
- FR-A- 1 583 109
- GB-A- 911 360
- US-A- 4 650 540
- US-A1- 2005 092 236

## Description

### FIELD OF THE INVENTION

The field of the invention relates to crystal growth apparatus and, in particular, crystal growth apparatus for continuous pulling of silicon ingots in which molten silicon does not contact an oxygen-containing crucible.

### BACKGROUND

Semiconductor grade single crystal silicon is used to produce various electronic devices. Single crystal silicon may be prepared by the so-called Czochralski method in which a silicon ingot is withdrawn from a melt of silicon held within a crucible within the crystal puller apparatus. Specifications for semiconductor grade single crystal silicon increasingly require lower grown-in oxygen specifications and require lower and tighter specifications for carbon. Such specifications may be difficult to achieve by Czochralski methods as the crucible used to hold the molten silicon is typically composed of silica which contains oxygen. Upon contact with molten silicon, oxygen from the silica crucible may enter the melt. Oxygen may be taken up by the growing ingot resulting in "grown-in" oxygen. The oxygen may also react with carbon that is introduced into the system through the polysilicon feedstock itself or through a susceptor that holds the crucible to produce carbon oxides which are soluble in the molten silicon. The carbon oxides are also taken up by the growing ingot which decreases device performance.

A need exists for crystal pulling apparatus which are able to use Czochralski pulling techniques for growing a single crystal silicon ingot with reduced grown-in oxygen and carbon.

US 4,650,540 A describes a method for producing mono-crystalline rods wherein a pool of molten crystalline material is rotated about a generally vertical axis, and a rod is withdrawn upwardly from the surface of an off-center portion of the pool so that material from the pool crystallizes at the interface therebetween to elongate the crystal structure of the rod. The rod is rotated at the same rotational velocity and in the same direction about a generally vertical axis parallel to and off-center from the rotational axis of the pool so that the relative motion at the pool-rod interface is uniform across the entire face of the rod.

### SUMMARY

The present invention is directed to a crystal growth apparatus for continuous preparation of a silicon ingot from a silicon melt. The apparatus has a vertical axis with a silicon ingot being pulled upward relative the vertical axis. The crystal growth apparatus comprises a base holding a solid silicon support. The solid silicon support has a top surface shaped for holding a silicon melting pool, a silicon stabilization pool and a silicon growth pool. The crystal growth apparatus includes a feed inlet for providing a continuous source of silicon material into the silicon melting pool. A first annular heater is mounted above the silicon melting pool for melting the silicon material or for maintaining the silicon material in a molten state. A second annular heater is mounted above the silicon stabilization pool. The second annular heater is within the first annular heater. At least a third annular heater is mounted above the silicon growth pool. The third annular heater is within the second annular heater.

The present invention is further directed to a method for growing a silicon ingot in the apparatus of the present invention, the method comprising:
continuously providing a source of silicon material into the silicon melting pool;
powering the first annular heater to melt silicon material or for maintaining the silicon material in a melted state, wherein molten silicon weirs over the melting pool into the stabilization pool;
powering the second annular heater to maintain a temperature in the stabilization pool, molten silicon weiring over the stabilization pool and into the growth pool; and
powering the third annular heater to control the ingot growth conditions, the ingot being withdrawn upward from the growth pool.

Various refinements exist of the features noted in relation to the above-mentioned aspects of the present invention. Further features may also be incorporated in the above-mentioned aspects of the present invention as well. These refinements and additional features may exist individually or in any combination. For instance, various features discussed below in relation to any of the illustrated embodiments of the present invention may be incorporated into any of the above-described aspects of the present invention, alone or in any combination.

### BRIEF DESCRIPTION OF THE DRAWINGS

Figure 1 is a schematic cross-section view of a crystal pulling apparatus having a solid silicon support;
Figure 2 is a detailed schematic of a lower portion of the crystal pulling apparatus; and
Figure 3 is a schematic cross-section view of a crystal pulling apparatus having a cooling chamber below the base.

Corresponding reference characters indicate corresponding parts throughout the drawings.

### DETAILED DESCRIPTION

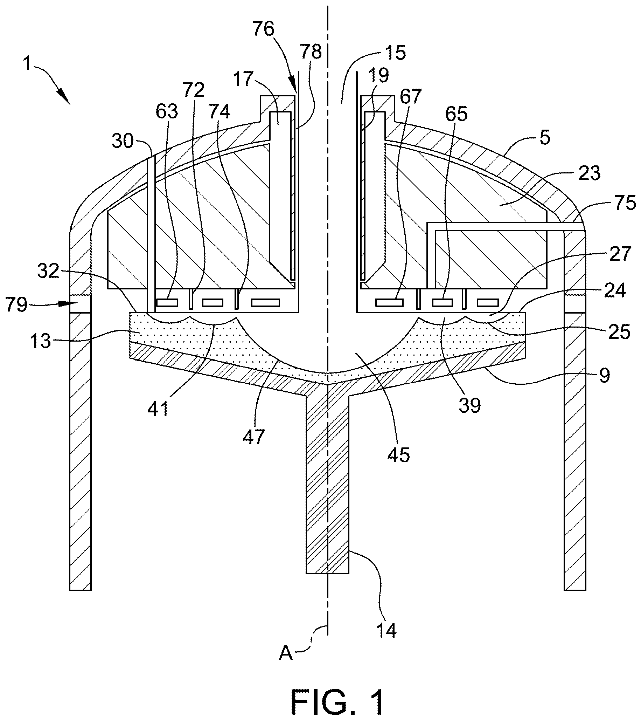

With reference to Figure 1, a crystal growth apparatus (which may also be referenced herein simply as a "crystal puller") is generally referenced as "1". The crystal growth apparatus 1 includes a housing 5 and a base 9 within the housing 5 for holding a solid silicon support 13. A pedestal 14 carries the base 9 and the solid silicon support 13. The pedestal 14 may rotate during crystal pulling to improve temperature and component gradients during crystal growth

The crystal puller 1 includes a central vertical axis A that is parallel to the direction in which the ingot 15 is pulled. The puller 1 also includes a cooling jacket 19 that surrounds the ingot 15 to maintain preferred temperature gradients in the ingot 15. An open area 17 separates the cooling jacket from insulation 23. Other crystal puller arrangements may be used including embodiments in which a heat shield (not shown) at least partially surrounds the ingot 15 or in which the cooling jacket 19 is eliminated and the insulation 23 extends further toward the ingot 15. Regardless of the arrangement, an opening 78 is positioned near the ingot for entry of inert gas into the crucible puller system.

The solid silicon support 13 is made of a multi-crystalline silicon billet, a single crystal silicon billet, or silicon plates. As referenced herein, a "silicon support" is made of elemental silicon and is intended to exclude compounds of silicon (e.g., silica, silicon carbide). The solid silicon support 13 may include various impurities; however, the amount of impurities should not exceed an amount that degrades the quality of the silicon ingot below acceptable levels. The solid silicon support 13 includes a top surface 24 that is shaped for holding three pools of silicon material. The solid silicon support 13 may be shaped by targeting melting of the silicon support (e.g., in the crystal puller 1 or before placement into the puller 1) or by machining the silicon support.

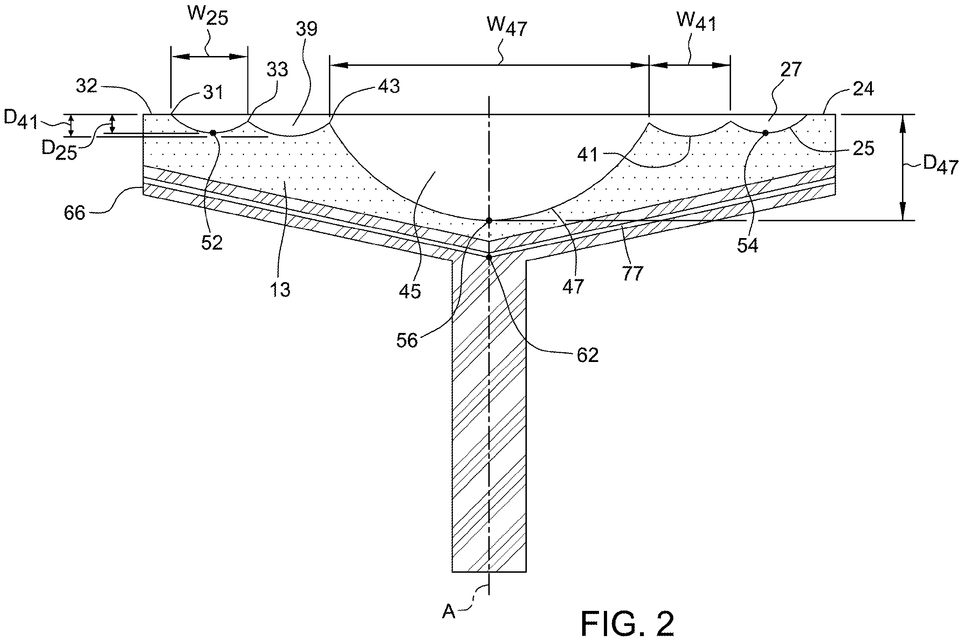

The base 9 that holds the solid silicon support 13 has a center 62 (Fig. 2) through which the vertical axis A passes and has a circumferential end 66. As shown in Figures 1 and 2, the base 9 slants downward from the circumferential end 66 to its center 62. In other embodiments, the base does not slant downward (e.g., may be horizontal). The base 9 may be contoured to optimize the shape of the various molten pools described below and to improve crystal puller heat management.

As shown in Figure 1, the top surface 24 includes at least three indentations for holding the molten silicon material - an annular silicon melting pool indentation 25, an annular stabilization pool indentation 41 and a growth pool indentation 47. An annular melting pool indentation 25 supports a silicon melting pool 27. Silicon is added through a feed inlet 30 to provide a continuous source of silicon material into the melting pool 27. Silicon may be added in solid form (e.g., granular silicon) in which the silicon melts within melting pool 27. A continuous feeder (not shown) may be used to supply granular silicon. In other embodiments, a pre-melter (not shown) which may be internal or external to the crystal puller housing 5 may be used to supply molten silicon to the pool 27 in which case the molten silicon material is maintained in a melted state in the pool.

The silicon support 13 includes the stabilization pool to allow silicon to fully melt and to maintain a consistent temperature before entering the growth pool 45. The solid silicon support 13 may also include more than three pools of silicon which may improve temperature and particle control but may add to the cost of the system.

The silicon melting pool 27 is held between an outer peak 31 (Fig. 2) and an inner peak 33 which define the indentation 25. The outer peak 31 may be part of an outer shelf 32 of the solid silicon support 13. The inner peak 33 is lower than the outer peak 31 relative to the vertical axis A to allow molten material to weir over the inner peak 33 and into the stabilization pool 39. The top surface 24 of the solid support 13 includes a stabilization pool outer peak 33 (which is the inner peak of the melting pool 27) and a stabilization pool inner peak 43 which define the annular stabilization indentation 41. The inner peak 43 is lower than the outer peak 31 of the melting pool indentation 25 relative to the vertical axis A to allow molten silicon to weir over the inner peak 43 and into the silicon growth pool 45. The inner peak 43 may be lower, at the same height or even higher than the stabilization pool outer peak 33. In some embodiments, the relative heights between the inner peak 43 and stabilization pool outer peak 33 is altered during crystal pulling to change the dynamics of the puller system.

The growth pool indentation 47 holds the molten silicon growth pool 45 from which an ingot 15 (Fig. 1) is withdrawn. The growth pool indentation 47 that holds the growth pool 45 is formed within the stabilization pool inner peak 43.

The melting pool indentation 25 has a width W₂₅ that extends from the outer peak 31 to the inner peak 33 and has a depth D₂₅ that is the vertical distance from its outer peak 31 to a bottom 52 of the indentation 25 (i.e., the lowest point of the indentation). The stabilization pool indentation 41 has a width W₄₁ that extends between its outer peak 33 and its inner peak 43 and has a depth D₄₁ that is the vertical distance from the outer peak 31 of the melting pool indentation 25 and a bottom 54 of the stabilization pool indentation 41. The growth pool indentation 47 had a width W₄₇ (i.e., diameter) and has a depth D₄₇ that is the vertical distance from the outer peak 31 of the melting pool indentation 25 to a bottom 56 of the growth pool indentation 47.

The depth D₄₇ of the growth pool indentation 47 is greater than both the depths D₂₅, D₄₁ of the melting pool indentation 25 and the stabilization pool indentation 41 to allow the growth pool indentation 47 to hold a larger volume of molten silicon. In various embodiments, the depth D₄₇ of the growth pool indentation 47 may be at least about twice or even at least about three times the depths D₂₅, D₄₁ of each of the melting pool indentation 25 and the stabilization pool indentation 41. The depth D₂₅ of the melting pool indentation 25, the depth D₄₁ of the stabilization pool indentation 41 and the depth D₄₇ of the growth pool indentation 47 may by controlled by the thermal gradients of the system which are chosen to produce stabile crystal growth.

Similarly, the width W₄₇ of the growth pool indentation 47 is greater than the widths W₂₅, W₄₁ of the melting pool indentation 25 and the stabilization pool indentation 41 to provide for proper surface area to withdraw the ingot 15 (Fig. 1) and to allow the growth pool to contain a sufficient volume of molten silicon. In various embodiments, the width W₄₇ of the growth pool indentation 47 may be at least about twice or even at least about three times the widths W₂₅, W₄₁ of each of the melting pool indentation 25 and the stabilization pool indentation 41. The melting pool indentation 25 and stabilization pool indentation 41 may have the same or different depths D₂₅, D₄₁ and widths W₂₅, W₄₁.

The solid silicon support 13 and silicon pools 27, 39, 45 and the ingot 15 (Fig. 1) are shown to illustrate use of the apparatus 1 and are not components of the apparatus unless stated otherwise. In some embodiments, the silicon support 13 is part of the apparatus.

The apparatus includes first, second and third annular heaters 63, 65, 67 for controlling the temperature profiles in the melting pool 27, stabilization pool 39 and growth pool 45, respectively. The first annular heater 63 is mounted above the melting pool 27 to melt granular silicon which is introduced into the pool 27 (or to maintain the silicon in a molten state when molten silicon is introduced into the pool). The first annular heater 63 may include an opening therein through which the solid or molten silicon passes.

Within this first annular heater 63 (i.e., within the central opening of the heater 63) is the second annular heater 65. The second annular heater 65 is mounted above the stabilization pool 39. The second annular heater 65 is controlled to maintain a consistent temperature of the silicon before entry into the growth pool 45 and to melt any solid silicon that weirs over from the melting pool 27. The third annular heater 67 is within the second annular heater 65 (within the central opening of the heater 65) and is mounted above the melting pool 45. The ingot 15 is withdrawn through the central opening of the third heater 67. The third heater 67 is controlled to maintain preferred temperature gradients in the ingot 15.

The three heaters 63, 65, 67 are independently controlled to provide sufficient heat to the silicon melting pool 27, stabilization pool 39 and growth pool 45 without melting the solid silicon support 13. The heaters 63, 65, 67 should be spaced a distance from the pools 27, 39, 45 that provides proper melt and stabilization temperatures without the heaters causing melt contamination (e.g., through dipping of heaters in the melt) and without excess heat being communicated to adjacent heating zones (i.e., to adjacent pools).

The heaters 63, 65, 67 may be resistance or RF heaters. While the heaters 63, 65, 67 may be described herein as being separate heaters, the heaters 63, 65, 67 may be combined in a single heating unit that allows three separate portions to be independently controlled to control heat input into the silicon melting pool 27, stabilization pool 39 and growth pool 45.

Insulation 23 (Fig. 1) extends above the heaters 63, 65, 67. The ingot 15 is pulled upward through the insulation 23. An outer divider 72 extends downward from the insulation 23 between the first annular heater 63 and the second annular heater 65. An inner divider 74 also extends downward from the insulation between the second annular heater 65 and the third annular heater 67. A first gas inlet 76 is in fluid communication with the opening 78 in through which the ingot 15 is pulled. Gas travels downward around the ingot 15 and over the surface of the growth pool 45 and past the stabilization pool 39 and melting pool 27. The dividers 72, 74 extend circumferentially around the axis A of the crystal puller 1 and force gas to flow across the surfaces of the molten silicon at relatively high gas velocity to carry away particles such as dust from feeding of granular silicon and any cooled and precipitated silicon monoxide.

The crystal puller 1 may include a second gas inlet 75 that discharges gas in the space formed between the outer divider 72 and the inner divider 74. Jets (not shown) may be used to direct gases across the surface of the growth pool 45, stabilization pool 39 and melting pool 27. Gases exit the system through an outlet 79 and may be cooled and further processed for re-use. The outlet 79 may be positioned at other portions of the crystal puller 1 such as at the bottom portion of the puller 1.

Gases which may be used in the crystal puller 1 and introduced through the first inlet 76 and the optional second inlet 75 are gases that are inert with regard to silicon and may include argon, nitrogen or even krypton or helium.

The base 9 may be composed of any material capable of supporting the solid silicon support 13 and silicon pools 27, 39, 45 at the temperatures and stresses of which the base 9 is typically exposed in crystal growing environments. Suitable materials may include silicon carbide, carbon, graphite, graphite insulation and refractory metals such as alumina or zirconia. While, in some embodiments, the base 9 may be eliminated and the solid silicon support 13 directly connected to the pedestal 14, it is generally preferred to incorporate a base 9 to provide sufficient structure and rigidity to the crystal pulling system. The base 9, support 13, insulation (if any) and heaters 63, 65, 67 should be configured to prevent the silicon pools 27, 39, 45 from extending to the base 9 while minimizing heat loss to reduce power consumption.

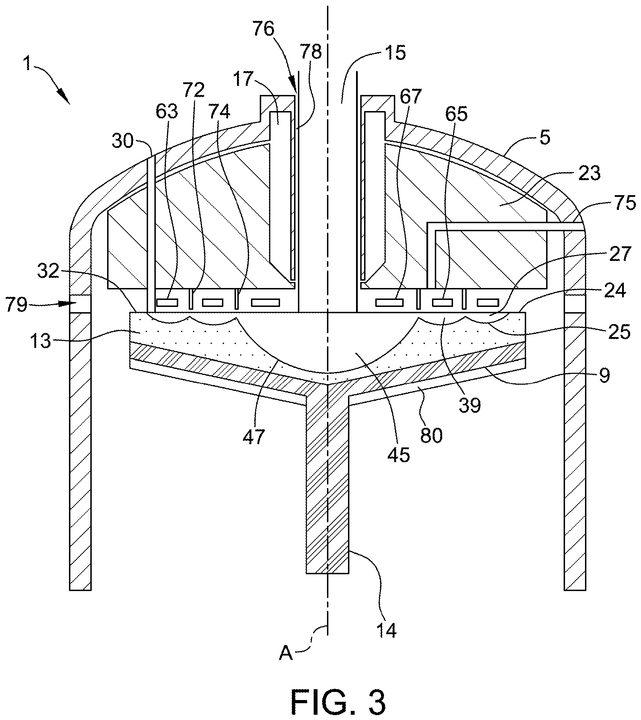

The base 9 may include cooling channels 77 (Fig. 2) formed therein for cooling the base 9 and the solid silicon support 13. In other embodiments and as shown in Figure 3, the base 9 is in fluid contact with a cooling chamber 80 (i.e., cooling jacket) in which a cooling fluid is circulated to cool the base 9 and the solid silicon support 13.

Preferably the apparatus does not include heaters or insulation below the base 9 to allow the base to properly cool. Insulation (not shown) may be included between the base 9 and the solid silicon support 13 to reduce heat loss.

Heaters (not shown) may be embedded in the solid silicon support 13 and, particularly, below the growth pool 45 to help maintain the growth pool 45 in a molten state. Such heaters may be resistive heaters or the silicon may be directly heated with inductively coupled RF heating. Temperature sensors (not shown) may be embedded in the base 9 or in the silicon support 13 to provide a temperature field that is used as feedback for power input for the heaters.

The crystal puller 1 may be operated by continually (or intermittently) adding a source of silicon to the feed inlet 30 while the ingot is withdrawn from the growth pool 45. The crystal puller 1 may be operated in a semi-continuous state in which ingot growth is only stopped upon nearing the limit of weight for the ingot neck or the ingot nearing the full length of the pull chamber. Once ingot growth is stopped, the ingot is removed from the growth chamber and the puller is re-seeded and ingot growth is reinitiated.

In the case of addition of solid silicon (e.g., granular silicon) the silicon is melted after it falls within the melting pool 27. In the case of addition of molten silicon (e.g., by use of a pre-melter), the silicon is maintained in its molten state in the pool 27. The first annular heater 63 is powered to melt silicon and/or maintain the added silicon in a molten state but not melt the solid silicon support 13 and including the inner peak 33 of the melting pool indentation 25. Addition of silicon into the pool 27 causes molten silicon to weir over the inner peak 33 (Fig. 2) and into the stabilization pool 39. The second annular heater 65 is powered and controlled to maintain a consistent temperature in the stabilization pool 39 (e.g., through feedback from a field of temperature sensors) which allows for tighter temperature control in the growth pool 45. Silicon weirs over the stabilization pool inner peak 43 and into the growth pool 45. The third annular heater 67 is powered to control the convections and temperature gradients in the pool 45 for proper ingot growth.

If it is desired to dope the ingot 15 (e.g., to prepare N-type or P-type silicon), dopant may be added continuously with the silicon or may be added through a separate inlet (not shown).

Generally, the first, second and third annular heaters 63, 65, 67 are powered continuously. The power supplied to the heaters 63, 65, 67 may be varied to control melting, stabilization and the growth conditions based on feedback from the temperature sensors. If the melting pool inner peak 33 or stabilization pool inner peak 43 is inadvertently melted, it may be reformed for proper transfer of silicon from the melting pool 27 into the stabilization pool 39 and into the growth pool 45.

Compared to conventional crystal pulling apparatus, the apparatus of the present invention has several advantages. The base and solid silicon support allow the puller to be operated without a crucible (i.e., a container having a floor and sidewall that is conventionally composed of silica). As the molten silicon contacts the solid silicon support rather than a crucible (e.g., silica crucible containing oxygen), less or no oxygen enters the melt. Less oxygen is available to react with carbon to produce carbon oxides that are soluble in molten silicon. Less dissolved oxygen and carbon allow an ingot with less oxygen and carbon to be produced. Such ingots produced by embodiments of the present invention may have less than about 3 ppm of oxygen and, in some embodiments, the resulting ingot contains oxygen in an amount less than the detection limit of oxygen. Alternatively or in addition, the ingots may contain less than about 0.001 ppm of carbon and may even contain carbon in an amount below the detection limit of carbon.

By using a continuous process, uniform axial and radial resistivity may be achieved through continuous doping. If oxygen is desired in the ingot, by not introducing oxygen into the system through the crucible, the melt may be doped with oxides to target and control grown-in oxygen.

Less oxygen in the melt allows less silicon oxide (SiO) to form, SiO being capable of reacting with carbon-containing system components in the exhaust which results in further CO and SiC formation which may degrade the lifetime of system components such as heater apparatus. Recued SiO in the system may allow some system components such as exhaust gas filtration systems, vacuum pumps and inert gas flow controllers to be reduced in size or eliminated. By reducing oxygen from the melt, the system components may operate longer due to less SiO fouling and the continuous system may operate longer to reduce the cost of operation.

By reducing or eliminating contact of the melt with an oxygen containing crucible, less oxygen enters the melt and the system pressure is not required to be operated as low as in conventional systems (e.g., below 50 torr) in which the pressure is relatively low to allow oxygen to out-diffuse from the melt. As less oxygen out-diffusion is needed, the system may be operated at a higher pressure which allows the flow rate of inert gas (e.g., argon) to be reduced as more gas is present at the higher pressure.

In embodiments in which the crystal puller includes dividers that extend downward toward the melt, the dividers act to force gas toward the surface of the melt and increase the velocity of the gas (which is sparse in vacuum systems) to move particles away from the growth pool, stabilization pool and melting pool. Use of a second gas inlet between an inner and outer divider helps maintain gas velocity as gas moves outward over the increasing crystal puller cross-section. In embodiments in which the crystal puller includes a base which slants downward toward its center, the distances between the base and the growth pool, stabilization pool and melting pool may be more uniform which results in a more uniform heating of the pools.

As used herein, the term "about" when used in conjunction with ranges of dimensions, concentrations, temperatures or other physical or chemical properties or characteristics is meant to cover variations that may exist in the upper and/or lower limits of the ranges of the properties or characteristics, including, for example, variations resulting from rounding, measurement methodology or other statistical variation.

When introducing elements of the present invention or the embodiment(s) thereof, the articles "a", "an", "the" and "said" are intended to mean that there are one or more of the elements. The terms "comprising," "including," "containing" and "having" are intended to be inclusive and mean that there may be additional elements other than the listed elements.

## Claims

1. A crystal growth apparatus (1) for continuous preparation of a silicon ingot (15) from a silicon melt, the apparatus having a vertical axis (A) with a silicon ingot being pulled upward relative the vertical axis, the crystal growth apparatus comprising:
a base (9) holding a solid silicon support (13), the support having a top surface (24) shaped for holding a silicon melting pool (27), a silicon stabilization pool (39) and a silicon growth pool (45);
a feed inlet (30) for providing a continuous source of silicon material into the silicon melting pool;
a first annular heater (63) mounted above the silicon melting pool for melting the silicon material or for maintaining the silicon material in a molten state;
a second annular heater (65) mounted above the silicon stabilization pool, the second annular heater being within the first annular heater; and
at least a third annular heater (67) mounted above the silicon growth pool, the third annular heater being within the second annular heater.

2. The crystal growth apparatus as set forth in claim 1 wherein the base (9) comprises a center (62) and a circumferential end (66), the base being contoured to match the shape of at least one of the silicon melting pool, silicon stabilization pool and silicon growth pool or is slanted downward from the circumferential end to its center.

3. The crystal growth apparatus as set forth in any one of claims 1 to 2 wherein the solid silicon support comprises a melting pool outer peak (31) and a melting pool inner peak (33), the inner peak being lower than the outer peak relative to the vertical axis to allow molten silicon to weir over the inner peak from the silicon melting pool and into the stabilization pool.

4. The crystal growth apparatus as set forth in claim 3 wherein the solid support comprises a stabilization pool outer peak (33) and a stabilization pool inner peak (43), the inner peak being lower than the melting pool outer peak relative to the vertical axis to allow molten silicon to weir over the inner peak from the silicon stabilization pool and into the silicon growth pool.

5. The crystal growth apparatus as set forth in claim 4 wherein the melting pool inner peak and the stabilization pool outer peak are the same peak.

6. The crystal growth apparatus as set forth in claim 5 wherein the solid support comprises a growth pool indentation (47) for holding the silicon growth pool, the indentation being within the stabilization pool inner peak (43).

7. The crystal growth apparatus as set forth in claim 6 wherein the melting pool outer peak (31) and inner peak (33) define an annular melting pool indentation (25) between the outer peak and the inner peak, the melting pool indentation having a depth that is the vertical distance from the outer peak to a bottom of the melting pool indentation, the stabilization pool outer peak (33) and stabilization pool inner peak (43) defining an annular stabilization pool indentation (41) between the outer peak and the inner peak, the stabilization pool indentation having a depth that is the vertical distance from the melting pool outer peak to a bottom of the stabilization pool indentation, the growth pool indentation (47) having a depth that is the vertical distance from the melting pool outer peak (31) to a bottom of the growth pool indentation, the depth of the growth pool indentation being greater than the depth of the melting pool indentation and the depth of the stabilization pool indentation.

8. The crystal growth apparatus as set forth in any one of claims 1 to 7 further comprising:
Insulation (23) that extends above the heaters; and
a divider (72) that extends downward from the insulation between the first annular heater and the second annular heater to force gas to flow across a surface of the molten silicon.

9. The crystal growth apparatus as set forth in claim 8 wherein the divider is an outer divider (72), the apparatus further comprising an inner divider (74) that extends downward from the insulation between the second annular heater and the third annular heater to force gas to flow across a surface of the molten silicon.

10. The crystal growth apparatus as set forth in claim 9 further comprising:
a first gas inlet (76) in fluid communication with an opening (78) within the insulation through which the ingot is pulled upward; and
a second gas inlet (75) that discharges gas into a space formed between the outer divider and the inner divider.

11. The crystal growth apparatus as set forth in any one of claims 1 to 10 wherein the base (1) comprises cooling channels (77) formed therein for cooling the base or (2) is in thermal contact with a cooling chamber (80) for exchanging heat with the base.

12. The crystal growth apparatus as set forth in any one of claims 1 to 11 wherein the base is comprised of silicon carbide, carbon, graphite, graphite insulation or refractory metals.

13. The crystal growth apparatus as set forth in any one of claims 1 to 12 wherein the apparatus does not comprise an oxygen-containing crucible.

14. A method for growing a silicon ingot in the apparatus of any one of claims 1 to 13, the method comprising:
continuously providing a source of silicon material into the silicon melting pool;
powering the first annular heater to melt silicon material or for maintaining the silicon material in a melted state, wherein molten silicon weirs over the melting pool into the stabilization pool;
powering the second annular heater to maintain a temperature in the stabilization pool, molten silicon weiring over the stabilization pool and into the growth pool; and
powering the third annular heater to control the ingot growth conditions, the ingot being withdrawn upward from the growth pool.

## Patentansprüche

1. Ein Kristallzüchtungsapparat (1) zur kontinuierlichen Herstellung eines Siliciumingots (15) aus einer Siliciumschmelze, wobei der Apparat eine vertikale Achse (A) hat und ein Siliciumingot relativ zu dieser vertikalen Achse nach oben gezogen wird, der Kristallzüchtungsapparat umfassend:
eine Basis (9) mit einem festen Siliciumsupport (13), wobei der Support eine obere Oberfläche (24) hat, die so geformt ist, dass sie einen Siliciumschmelz-Pool (27), einen Siliciumstabilisierungs-Pool (39) und einen Siliciumwachstums-Pool (45) aufnehmen kann;
einen Feed-Einlass (30) zur kontinuierlichen Gabe einer Quelle für Siliciummaterial in den Siliciumschmelz-Pool;
einen ersten ringförmigen Heizer (63), der oberhalb des Siliciumschmelz-Pools angebracht ist, zum Schmelzen des Siliciummaterials oder um das Siliciummaterial in einem geschmolzenen Zustand zu halten;
einen zweiten ringförmigen Heizer (65), der oberhalb des Siliciumstabilisierungs-Pools angebracht ist, wobei sich der zweite ringförmige Heizer innerhalb des ersten ringförmigen Heizers befindet; und
mindestens einen dritten ringförmigen Heizer (67), der oberhalb des Siliciumwachstums-Pools angebracht ist, wobei sich der dritte ringförmige Heizer innerhalb des zweiten ringförmigen Heizers befindet.

2. Der Kristallzüchtungsapparat gemäß Anspruch 1 wobei die Basis (9) eine Mitte (62) und eine Umfangskante (66) hat und die Basis so konturiert ist, dass sie zur Form von mindestens einem des Siliciumschmelz-Pools, Siliciumstabilisierungs-Pools und Siliciumwachstums-Pools passt, oder von der Umgangskante zur Mitte hin abschüssig ist.

3. Der Kristallzüchtungsapparat gemäß irgendeinem der Ansprüche 1 bis 2 wobei der feste Siliciumsupport einen Schmelzpool-Außenrand (31) und einen Schmelzpool-Innenrand (33) besitzt, wobei der Innenrand relativ zur vertikalen Achse niedriger als der Außenrand ist, so dass geschmolzenes Silicium aus dem Siliciumschmelz-Pool über den Innenrand und in den Stabilisierungs-Pool überlaufen kann.

4. Der Kristallzüchtungsapparat gemäß Anspruch 3 wobei der feste Support einen Stabilisierungspool-Außenrand (33)) und einen Stabilisierungspool-Innenrand (43), wobei der Innenrand relativ zur vertikalen Achse niedriger als der Außenrand ist, so dass geschmolzenes Silicium aus dem Siliciumstabilisierungs-Pool über den Innenrand und in den Siliciumwachstums-Pool überlaufen kann..

5. Der Kristallzüchtungsapparat gemäß Anspruch 4 wobei der Schmelz-Pool-Innenrand und der Stabilisierungs-Pool-Außenrand derselbe Rand sind.

6. Der Kristallzüchtungsapparat gemäß Anspruch 5 wobei der feste Support eine Wachstumspool-Vertiefung (47) besitzt, um den Siliciumwachstums-Pool aufzunehmen, wobei die Vertiefung sich innerhalb des Stabilisierungs-Pool-Innenrands befindet (43).

7. Der Kristallzüchtungsapparat gemäß Anspruch 6 wobei der Schmelzpool-Außenrand (31) und -Innenrand (33) eine ringförmige Schmelzpool-Vertiefung (25) zwischen dem Außenrand und dem Innenrand bilden, wobei die Schmelzpool-Vertiefung eine Tiefe hat, welche die vertikale Distanz zwischen dem Außenrand und dem Grund der Schmelzpool-Vertiefung ist, wobei der Stabilisierungspool-Außenrand (33) und Stabilisierungspool-Innenrand (43) eine ringförmige Stabilisierungspool-Vertiefung (41) zwischen dem Außenrand und dem Innenrand bilden, wobei die Stabilisierungspool-Vertiefung eine Tiefe hat, welche die vertikale Distanz zwischen dem Schmelzpool-Außenrand und dem Grund der Stabilisierungspool-Vertiefung ist, wobei die Wachstumspool-Vertiefung (47) eine Tiefe hat, welche die vertikale Distanz zwischen dem Schmelzpool-Außenrand (31) und dem Grund der Wachstumspool-Vertiefung ist, wobei die Tiefe der Wachstumspool-Vertiefung größer ist als die Tiefe der Schmelzpool-Vertiefung und die Tiefe der Stabilisierungspool-Vertiefung.

8. Der Kristallzüchtungsapparat gemäß irgendeinem der Ansprüche 1 bis 7 außerdem umfassend:
eine Isolierung (23) welche sich oberhalb der Heizer erstreckt; und
einen Teiler (72) welcher sich von der Isolierung aus zwischen dem ersten ringförmigen Heizer und dem zweiten ringförmigen Heizer nach unten erstreckt, um Gas dazu zu zwingen, über eine Oberfläche des geschmolzenen Siliciums zu strömen.

9. Der Kristallzüchtungsapparat gemäß Anspruch 8 wobei der Teiler ein äußerer Teiler (72), der Apparat außerdem umfassend einen inneren Teiler (74) welcher sich von der Isolierung aus zwischen dem zweiten ringförmigen Heizer und dem dritten ringförmigen Heizer nach unten erstreckt, um Gas dazu zu zwingen, über eine Oberfläche des geschmolzenen Siliciums zu strömen.

10. Der Kristallzüchtungsapparat gemäß Anspruch 9 außerdem umfassend:
einen ersten Gaseinlass (76) in fluider Kommunikation mit einer Öffnung (78) in der Isolierung, durch die der Ingot nach oben gezogen wird; und
einen zweiten Gaseinlass (75) welcher Gas in einen Zwischenraum zwischen dem äußeren Teiler und dem inneren Teiler abgibt.

11. Der Kristallzüchtungsapparat gemäß irgendeinem der Ansprüche 1 bis 10 wobei (1) sich in der Basis Kühlkanäle (77) befinden, um die Basis zu kühlen, oder (2) die Basis in thermischem Kontakt mit einer Kühlkammer (80) ist, um einen Hitzeaustausch mit der Basis zu ermöglichen.

12. Der Kristallzüchtungsapparat gemäß irgendeinem der Ansprüche 1 bis 11 wobei die Basis aus Siliciumcarbid, Kohlenstoff, Graphit, Graphitisolierung oder Refraktärmetallen besteht.

13. Der Kristallzüchtungsapparat gemäß irgendeinem der Ansprüche 1 bis 12 wobei der Apparat keinen sauerstoffhaltigen Tiegel umfasst.

14. Ein Verfahren zur Herstellung eines Siliciumingots im Apparat gemäß irgendeinem der Ansprüche 1 bis 13, das Verfahren umfassend:
kontinuierliche Gabe einer Quelle für Siliciummaterial in den Siliciumschmelz-Pool;
Betreiben des ersten ringförmigen Heizers, um Siliciummaterial zu schmelzen oder um das Siliciummaterial in einem geschmolzenen Zustand zu halten, wobei geschmolzenes Silicium über den Rand des Schmelzpools in den Stabilisierungs-Pool überläuft;
Betreiben des zweiten ringförmigen Heizers, um eine Temperatur im Stabilisierungs-Pool aufrechtzuerhalten, wobei geschmolzenes Silicium über den Rand des Stabilisierungs-Pools und in den Wachstums-Pool überläuft; und
Betreiben des dritten ringförmigen Heizers, um die Ingot-Wachstumsbedingungen einzustellen, wobei der Ingot nach oben aus dem Wachstumspool gezogen wird.

## Revendications

1. Un appareil (1) de croissance de cristaux pour la préparation continue d'un lingot de silicium (15) à partir d'une masse fondue de silicium, l'appareil ayant un axe vertical (A), un lingot de silicium étant tiré vers le haut par rapport à l'axe vertical, l'appareil de croissance de cristaux comprenant :
une base (9) portant un support (13) de silicium solide, le support ayant une surface supérieure (24) formée pour maintenir un bassin (27) de fusion de silicium, un bassin (39) de stabilisation de silicium et un bassin (45) de croissance de silicium ;
une entrée d'alimentation (30) pour fournir une source continue de matériau de silicium dans le bassin de fusion de silicium ;
un premier appareil de chauffage annulaire (63) monté au-dessus du bassin de fusion de silicium pour faire fondre le matériau de silicium ou pour maintenir le matériau de silicium dans un état fondu ;
un deuxième appareil de chauffage annulaire (65) monté au-dessus du bassin de stabilisation de silicium, le deuxième appareil de chauffage annulaire étant à l'intérieur du premier appareil de chauffage annulaire ; et
au moins un troisième appareil de chauffage annulaire (67) monté au-dessus du bassin de croissance de silicium, le troisième appareil de chauffage annulaire étant à l'intérieur du deuxième appareil de chauffage annulaire.

2. L'appareil de croissance de cristaux selon la revendication 1, dans lequel la base (9) comprend un centre (62) et une extrémité circonférentielle (66), la base étant profilée de façon à correspondre à la forme d'au moins un parmi le bassin de fusion de silicium, le bassin de stabilisation de silicium et le bassin de croissance de silicium ou étant inclinée vers le bas depuis l'extrémité circonférentielle vers son centre.

3. L'appareil de croissance de cristaux selon l'une quelconque des revendications 1 à 2, dans lequel le support de silicium solide comprend une crête externe (31) de bassin de fusion et une crête interne (33) de bassin de fusion, la crête interne étant plus basse que la crête externe par rapport à l'axe vertical de façon à permettre au silicium fondu de s'écouler au-dessus de la crête interne depuis le bassin de fusion de silicium et dans le bassin de stabilisation.

4. L'appareil de croissance de cristaux selon la revendication 3, dans lequel le support solide comprend une crête externe (33) de bassin de stabilisation et une crête interne (43) de bassin de stabilisation, la crête interne étant plus basse que la crête externe de bassin de fusion par rapport à l'axe vertical de façon à permettre au silicium fondu de s'écouler par-dessus la crête interne depuis le bassin de stabilisation de silicium et dans le bassin de croissance de silicium.

5. L'appareil de croissance de cristaux selon la revendication 4, dans lequel la crête interne du bassin de fusion et la crête externe du bassin de stabilisation sont la même crête.

6. L'appareil de croissance de cristaux selon la revendication 5, dans lequel le support solide comprend une empreinte (47) de bassin de croissance pour maintenir le bassin de croissance de silicium, l'empreinte étant faite dans la crête interne (43) de bassin de stabilisation.

7. L'appareil de croissance de cristaux selon la revendication 6, dans lequel la crête externe (31) et la crête interne (33) du bassin de fusion définissent une empreinte annulaire (25) de bassin de fusion entre la crête externe et la crête interne, l'empreinte de bassin de fusion ayant une profondeur qui est la distance verticale entre la crête externe et un fond de l'empreinte de bassin de fusion, la crête externe (33) de bassin de stabilisation et la crête interne (43) de bassin de stabilisation définissant une empreinte annulaire (41) de bassin de stabilisation entre la crête externe et la crête interne, l'empreinte du bassin de stabilisation ayant une profondeur qui est la distance verticale entre la crête externe du bassin de fusion et un fond de l'empreinte du bassin de stabilisation, l'empreinte (47) du bassin de croissance ayant une profondeur qui est la distance verticale entre la crête externe (31) du bassin de fusion et un fond de l'empreinte du bassin de croissance, la profondeur de l'empreinte du bassin de croissance étant supérieure à la profondeur de l'empreinte du bassin de fusion et à la profondeur de l'empreinte du bassin de stabilisation.

8. L'appareil de croissance de cristaux selon l'une quelconque des revendications 1 à 7 comprenant en outre :
une isolation (23) qui s'étend au-dessus des appareils chauffants ; et
un diviseur (72) qui s'étend vers le bas à partir de l'isolation entre le premier appareil chauffant annulaire et le deuxième appareil chauffant annulaire de façon à forcer le gaz à s'écouler à travers une surface de silicium fondu.

9. L'appareil de croissance de cristaux selon la revendication 8, dans lequel le diviseur est un diviseur externe (72), l'appareil comprenant en outre un diviseur interne (74) qui s'étend vers le bas depuis l'isolation entre le deuxième appareil chauffant annulaire et le troisième appareil chauffant annulaire de façon à forcer le gaz à s'écouler sur une surface du silicium fondu.

10. L'appareil de croissance de cristaux selon la revendication 9, comprenant en outre :
une première entrée de gaz (76) en communication fluidique avec une ouverture (78) à l'intérieur de l'isolation à travers laquelle le lingot est tiré vers le haut ; et
une deuxième entrée de gaz (75) qui décharge du gaz dans un espace formé entre le diviseur externe et le diviseur interne.

11. L'appareil de croissance de cristaux selon l'une quelconque des revendications 1 à 10, dans lequel la base (1) comprend des canaux de refroidissement (77) formés à l'intérieur d'elle pour refroidir la base ou (2) est en contact thermique avec une chambre de refroidissement (80) pour échanger de la chaleur avec la base.

12. L'appareil de croissance de cristaux selon l'une quelconque des revendications 1 à 11, dans lequel la base est constituée de carbure de silicium, de carbone, de graphite, d'isolant en graphite ou de métaux réfractaires.

13. L'appareil de croissance de cristaux selon l'une quelconque des revendications 1 à 12, dans lequel l'appareil ne comporte pas de creuset contenant de l'oxygène.

14. Un procédé de croissance d'un lingot de silicium dans l'appareil selon l'une quelconque des revendications 1 à 13, le procédé comprenant :
le fait de fournir en continu une source de matériau silicium dans le bassin de fusion de silicium ;
le fait d'activer le premier appareil de chauffage annulaire de façon à faire fondre le matériau silicium ou à maintenir le matériau silicium dans un état fondu, le silicium fondu s'écoulant au-dessus du bassin de fusion jusque dans le bassin de stabilisation ;
le fait d'activer le deuxième appareil de chauffage annulaire de façon à maintenir une température dans le bassin de stabilisation, le silicium fondu s'écoulant au-dessus du bassin de stabilisation et jusque dans le bassin de croissance ; et
le fait d'activer le troisième appareil de chauffage annulaire de façon à commander les conditions de croissance du lingot, le lingot étant soutiré vers le haut à partir du bassin de croissance.
